(19) Europäisches Patentamt

European Patent Office

Office européen des brevets

(11) EP 1 296 548 A2

(12) EUROPEAN PATENT APPLICATION

(43) Date of publication:
26.03.2003 Bulletin 2003/13

(51) Int Cl.$^7$: H05K 13/08

(21) Application number: 02020112.5

(22) Date of filing: 07.09.2002

(84) Designated Contracting States:
AT BE BG CH CY CZ DE DK EE ES FI FR GB GR IE IT LI LU MC NL PT SE SK TR
Designated Extension States:
AL LT LV MK RO SI

(30) Priority: 21.09.2001 JP 2001290133

(71) Applicant: Sanyo Electric Co., Ltd.
Moriguchi-shi, Osaka 570-8677 (JP)

(72) Inventors:
• Ohuchi, Atsushi, Sanyo Electric Co., Ltd.
Moriguchi City, Osaka 570-8677 (JP)

• Sugata, Takuji, Sanyo Electric Co., Ltd.
Moriguchi City, Osaka 570-8677 (JP)
• Ozawa, Yoshio, Sanyo Electric Co., Ltd.
Moriguchi City, Osaka 570-8677 (JP)

(74) Representative: Selting, Günther, Dipl.-Ing. et al
Patentanwälte
von Kreisler, Selting, Werner
Postfach 10 22 41
50462 Köln (DE)

(54) **Parts arranging method and parts mounting apparatus**

(57) In a parts mounting apparatus wherein a plurality of feeders each storing one type of parts are disposed at predetermined positions and as a mounting head moves, electronic parts unloaded from the feeders are mounted to a printed circuit board at a plurality of mounting points, movement time for the mounting head to move from the respective mounting points on the printed circuit board to the respective feeders is calculated, the total of the movement time calculated for the respective mounting points is calculated for each one of the feeders, and one feeder which is to store the electronic parts is determined based on the calculated total time. As the electronic parts are stored in the determined feeder, this ensures that the mounting time for mounting the electronic parts to the printed circuit board becomes the shortest.

FIG. 3

**Description**

BACKGROUND OF THE INVENTION

The present invention relates to a parts arranging method for determining a storage unit in which electronic parts to be mounted should be placed in a parts mounting apparatus for mounting electronic parts to be mounted which are stored in storage units in advance to a substrate such as a printed circuit board using a mounting head.

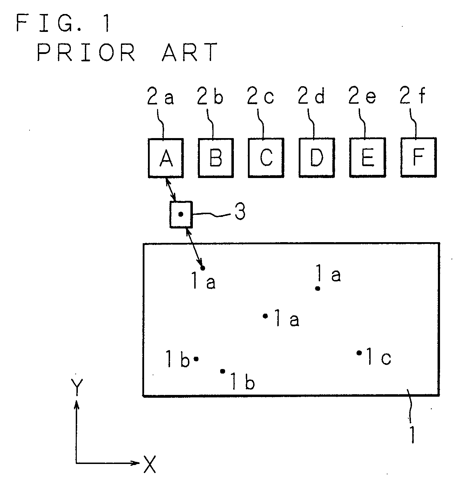

FIG. 1 is a schematic diagram which shows an operating state of a parts mounting apparatus which mounts electronic parts to a printed circuit board. In FIG. 1, denoted by 1 is a printed circuit board to which electronic parts are mounted at predetermined mounting points 1a through 1c. The printed circuit board 1 is transported by a transportation mechanism (not shown) and set at a predetermined position. At the mounting points on the printed circuit board 1 denoted by the same reference symbol, identical types of electronic parts are mounted. In the example in FIG. 1, electronic parts A are mounted to the three mounting points 1a, electronic parts B are mounted to the two mounting points 1b and an electronic part C is mounted to the mounting point 1c.

In the vicinity of the position at which the printed circuit board 1 is set, a plurality of (six in this example) feeders (parts storage units) 2a through 2f storing electronic parts which are to be mounted to the printed circuit board 1 are arranged in a row. Each one of the feeders 2a through 2f stores one type of electronic parts. In the example in FIG. 1, electronic parts A, B, ..., F are stored in the feeders 2a, 2b, ..., 2f, respectively.

In addition, there is a mounting head 3 which moves in two dimensions (XY system) by means of a predetermined drive mechanism (not shown). The mounting head 3 moves between the printed circuit board 1 and the respective feeders 2a through 2f and mounts the electronic parts to the printed circuit board 1. For instance, the mounting head 3 moves to the feeder 2a which stores the electronic parts A, sucks and takes out the electronic parts A stored in the feeder 2a, and thereafter moves to the mounting point 1a on the printed circuit board 1 and mounts the sucked electronic part A at the mounting point 1a. Similar operations are repeated following this, whereby the corresponding electronic parts A through C are mounted one after another at all mounting points 1a through 1c.

In such a parts mounting apparatus, it is desirable to efficiently move the mounting head 3 for the purpose of shortening the time required for the mounting work. The positions of the mounting points on the printed circuit board 1 are determined in advance and a type of electronic parts to be stored in a feeder can be freely set by a user, and therefore, the arrangement of the feeders which store various types of electronic parts has a great influence over the mounting time. It is an important factor for reduction of the mounting time to set which type of electronic parts are to be stored in which feeder at which position. In short, efficient determination of the feeder makes it possible to complete the mounting processing in a short period of time.

Noting such a factor, a conventional approach (such as Japanese Patent Application Laid-Open No. H8-167796(1996)) for reduction of the mounting time demands that electronic parts which are to be mounted at a certain mounting point are stored in a feeder which is at a shortest distance from the coordinate position of the mounting point (When one type needs be mounted at more than one mounting point, this type of electronic parts are stored in a feeder which is at a shortest distance from an average value (center of gravity position) of the coordinate positions of those mounting points.).

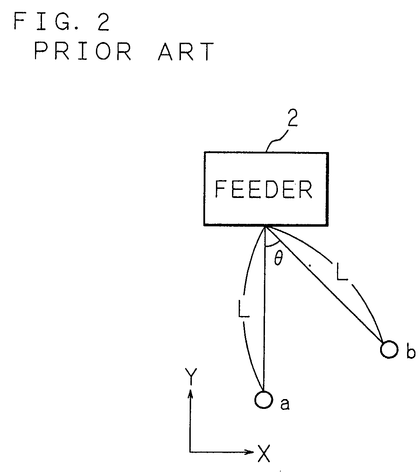

The conventional method above has a problem that the mounting time may not always be shortened because the feeder for storing is determined based on the distance between the mounting point(s) and the feeder. As shown in FIG. 2, when distances (L) from two mounting points a and b to a certain feeder 2 are equal, movement times for a mounting head to move from these two mounting points a and b to the feeder 2 are different from each other. Since the mounting head can be driven independently in an X-direction and a Y-direction for instance and can move in the X-direction and the Y-direction at the same time, on the assumption that the mounting head moves at the same speed each in the X-direction and the Y-direction, even if the distances (L) to the feeder 2 are equal, the movement time $T_a$ and $T_b$ from the mounting points a and b are expressed by the following formulas (1) and (2). Thus, the movement time from the mounting point b is shorter ($T_b < T_a$).

$$T_a = L/v_Y \tag{1}$$

$$T_b = \max(L\sin\theta/v_X, L\cos\theta/v_Y) \tag{2}$$

where

$\theta$: angle from the mounting point b with respect to the Y-direction

$v_X$ : moving speed at which the mounting head moves in the X-direction

$v_Y$ : moving speed at which the mounting head moves in the Y-direction

$\max(p, q)$ : any one between p and q that is not smaller

As described above, the distance from the mounting point to the feeder is not proportional to the movement time of the mounting head or does not accurately reflect the movement time, and therefore, it cannot be said that the feeder is efficiently determined according to the conventional approach and the mounting time is not always shortened.

BRIEF SUMMARY OF THE INVENTION

A principal object of the present invention is to provide a parts arranging method and a parts mounting apparatus with which it is possible to determine storage units (feeders) considering the movement time of a mounting head, efficiently determine the storage units (feeders) and accordingly reduce time for mounting parts without fail.

In a parts arranging method according to the present invention for determining a storage unit to store parts for a parts mounting apparatus in which a plurality of storage units each storing one type of parts and a substrate to which the parts are mounted at a plurality of mounting points are disposed at predetermined positions, and a mounting head moves, accordingly transports a corresponding part from the storage units and mounts the part to the substrate, the parts arranging method is characterized in comprising the steps of calculating movement time for the mounting head to move from the respective mounting points on the substrate to the respective storage units; calculating, for each one of the storage units, the total of a plurality of lengths of movement time calculated for the respective mounting points; and determining a storage unit which is to store the parts based on the calculated total time.

According to the present invention, the movement time of the mounting head to travel from the respective mounting points on the substrate to the respective storage units is calculated, and the total of the movement time calculated for the respective mounting points is calculated for each storage unit. Based on the calculated total time, to be more specific, the storage unit for which the total time is the shortest is determined as a storage unit which is to store the corresponding type of parts. Since the storage unit is determined considering the movement time of the mounting head, which is directly linked to the mounting time of the parts, it is possible to determine the storage unit so as to reliably shorten the mounting time of the parts.

In addition, the present invention is characterized in that at the stage of determining the storage units which are to store the plurality of types of parts, a storage unit which is to store the parts which are to be mounted in greater number is given priority.

At the stage of determining optimal storage units for a plurality of types of parts, a storage unit is determined for parts which are to be mounted in greater number with a higher priority than for those parts which are to be mounted in a small number. When processing for determining the storage units according to the first aspect of the invention is executed for each of a plurality of types of parts, storage units to be determined may overlap in some cases. In such cases, a storage unit is set for the parts to be mounted in greater number, namely, for those parts which are to be mounted at a greater number of mounting points on the substrate. In this manner, it is possible to efficiently determine the storage parts for the plurality of types of electronic parts.

The above and further objects and features of the invention will more fully be apparent from the following detailed description with the accompanying drawings.

BRIEF DESCRIPTION OF THE SEVERAL VIEWS OF THE DRAWINGS

FIG. 1 is a schematic diagram which shows an operating state of a parts mounting apparatus;
FIG. 2 is a drawing which shows a positional relationship between a feeder and two mounting points which are at equal distances from the feeder;
FIG. 3 is a schematic diagram which shows an operating state of a parts mounting apparatus to which a parts arranging method according to the present invention is applied;
FIG. 4 is a flowchart which shows the sequence of processing in a method for determining storage units (feeders) according to the present invention;
FIG. 5 is a drawing which shows one example of a positional relationship between a mounting point and feeders and a distribution of movement time of a mounting head;
FIG. 6 is a drawing which shows another example of a positional relationship between a mounting point and feeders and a distribution of movement time of a mounting head;
FIG. 7 is a drawing which shows still another example of a positional relationship between a mounting point and feeders and a distribution of movement time of a mounting head;
FIG. 8 is a chart which shows, for each feeder, movement time of a mounting head to three mounting points and the total time; and
FIG. 9 is a chart which shows, for each feeder, the number of mounted parts for the four types of electronic parts and total movement time of a mounting head.

DETAILED DESCRIPTION OF THE INVENTION

Preferred embodiments of the present invention will now be described specifically with reference to the associated drawings.

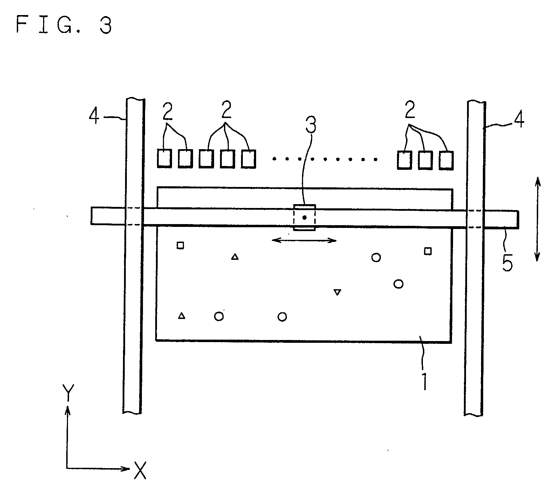

FIG. 3 is a schematic diagram which shows an operating state of a parts mounting apparatus to which a parts arranging method according to the present invention is applied. In FIG. 3, denoted by 1 is a printed circuit board to which electronic parts are mounted at predetermined mounting points (which are denoted by o, Δ, ▽, □). The printed circuit board 1 is transported by a transportation mechanism (not shown) and set at a predetermined position. At the mounting points on the printed circuit board 1 denoted by the same reference symbol, the same type of electronic parts are mounted.

In the vicinity of the position at which the printed circuit board 1 is set, a plurality of (eighteen in this example) feeders (parts storage units) 2, 2, ..., 2 which store electronic parts to be mounted to the printed circuit board 1 are arranged in a row. Each one of the feeders 2 stores one type of electronic parts. In this example, a maximum of eighteen types of electronic parts in total can be stored.

Further, a rod-like beam 5 stretches across paired rails 4 and 4 which are opposed to each other, and the mounting head 3 is provided on the beam 5. When driven by a Y-direction drive motor (not shown), the beam 5 can move in the Y-direction along the rails 4 and 4. Meanwhile, when driven by an X-direction drive motor (not shown), the mounting head 3 provided on the beam 5 can move in the X-direction along the beam 5. The X-direction drive motor and the Y-direction drive motor can be driven independently, so that the mounting head 3 can move in the X-direction and the Y-direction independently at the same time. Moving between the printed circuit board 1 and the respective feeders 2, 2, ..., 2, the mounting head 3 mounts corresponding electronic parts to the respective mounting portions on the printed circuit board 1.

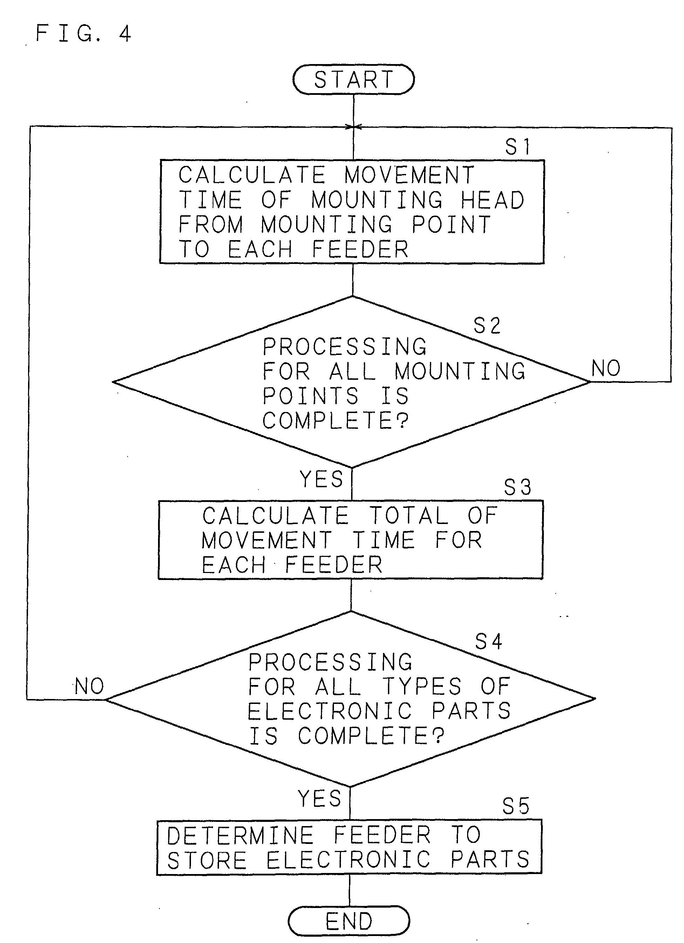

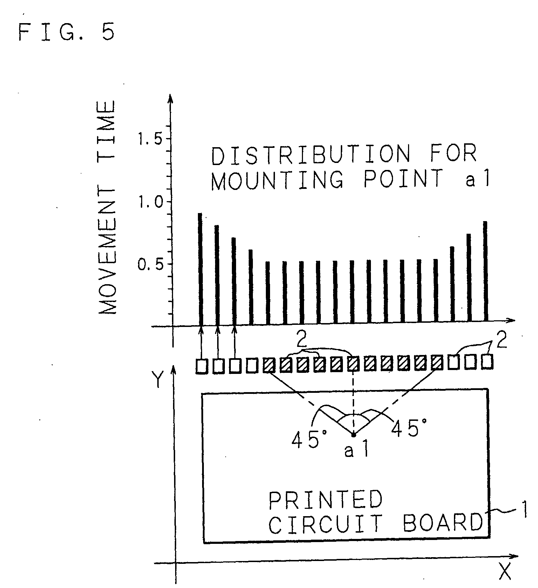

Next, a method for determining the storage units (feeders) which are characteristic units according to the present invention will now be described in detail. FIG. 4 is a flowchart which shows the sequence of processing in the method, and FIG. 5 through FIG. 9 are drawings for illustrating operations according to the method.

(First Preferred Embodiment)

An example will be described as a first preferred embodiment in which one type of electronic parts (electronic parts A) is to be set to the printed circuit board 1, and the electronic parts A are to be mounted to the printed circuit board 1 at three mounting points (a1, a2, a3), and an optimal feeder 2 is determined from among eighteen feeders 2, 2, ..., 2 so as to store the electronic parts A.

First, movement time required for the mounting head 3 to move from the mounting point a1 on the printed circuit board 1 to the eighteen feeders 2, 2, ..., 2 are calculated (Step S1). FIG. 5 shows a positional relationship between the mounting point a1 and the feeders 2 and a distribution of the movement time (bar chart). As described earlier, the mounting head 3 can move in the X-direction and the Y-direction independently at the same time, the movement time to the eleven feeders 2 located in a central area which is within the region denoted by the dashed lines in FIG. 5 are the shortest time (0.5 second) which is constant. When the moving speeds of the mounting head 3 in the X-direction and the Y-direction are the same, the movement time to all feeders 2 which are in the range from -45 degrees to 45 degrees with respect to the Y-direction from the mounting point a1 is the constant shortest time.

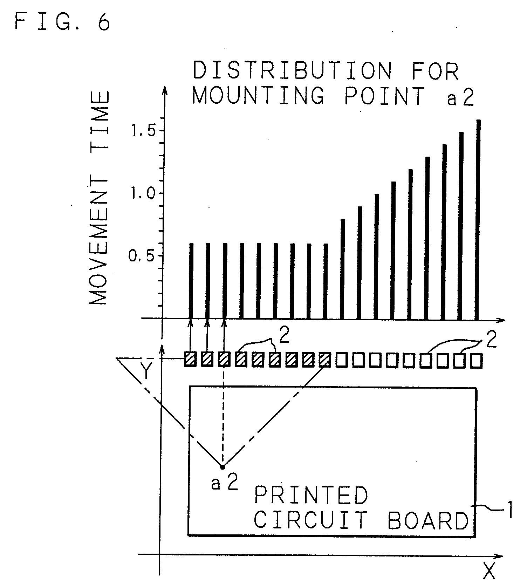

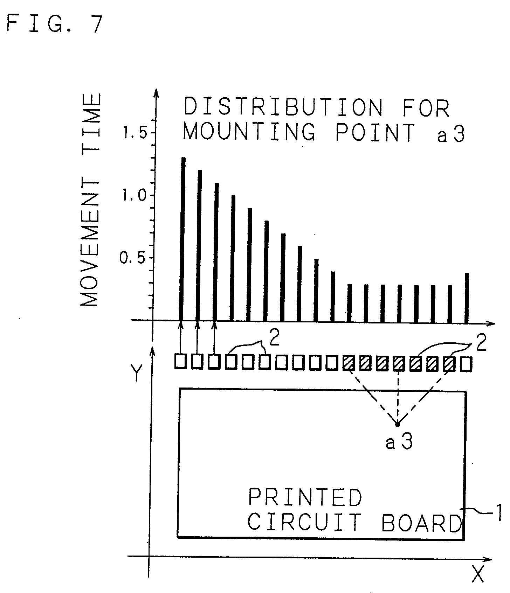

Next, since processing for calculating the movement time to all mounting points is not yet complete (Step S2 : NO), the movement time of the mounting head 3 to each of the eighteen feeders 2, 2, ..., 2 from the mounting point a2 on the printed circuit board 1 is calculated (S1). FIG. 6 shows a positional relationship between the mounting point a2 and the feeders 2 and a distribution of the movement time. Further, since the processing of calculating the movement time to the mounting point a3 still remains (S2 : NO), the movement time of the mounting head 3 to each of the eighteen feeders 2, 2, ..., 2 from the mounting point a3 on the printed circuit board 1 is calculated (S1). FIG. 7 shows a positional relationship between the mounting point a3 and the feeders 2 and a distribution of the movement time.

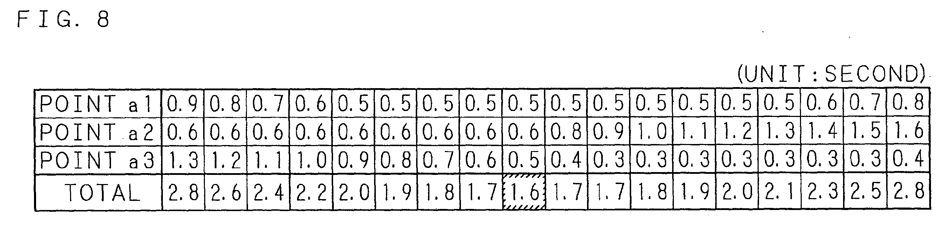

Since processing at all three mounting points is now complete (S2 : YES), the sum of the three types of calculated movement time distributions (total of the movement time) is calculated (Step 3). FIG. 8 shows, for each one of the eighteen feeders 2, 2, ..., 2, the movement time at the respective mounting points a1, a2 and a3 and the total movement time in the form of a table.

In the first preferred embodiment, since there is only one type of electronic parts, the processing for all types of electronic parts is now complete (Step S4 : YES), and therefore, an optimal feeder 2 which is to store the electronic parts A is determined based on the sum of the movement time distributions calculated at S3 (total of the movement time) (Step S5). In short, the feeder 2 (the ninth feeder 2 from the extreme left) for which the total time shown in FIG. 8 is the shortest (1.6 seconds) is determined as an optimal feeder 2.

(Second Preferred Embodiment)

An example will be described as a second preferred embodiment in which four types of electronic parts (electronic parts A, B, C, D)are set to the printed circuit board 1, and the electronic parts A, B, C and D are to be mounted to the printed circuit board 1 respectively at twenty mounting points, fifteen mounting points, eight mounting points and four mounting points, and an optimal feeder is determined from among four feeders F1, F2, F3 and F4 for each one of the four types of electronic parts A, B, C and D. In this case, since the number of types of electronic parts is the same as the number of feeders, the feeders correspond to the four types of electronic parts A, B, C and D in a 1 : 1 relationship and the four types of electronic parts are allotted to four feeders.

In a similar fashion to that of the first preferred embodiment, first, a distribution of movement time to the twenty mounting points is calculated for the electronic parts A (S1, S2), and the sum of these (total of movement time) is then calculated (S3). Since processing for all types of electronic parts is not yet complete (S4 : NO), distributions of movement time for the electronic parts B, C and D are calculated (S1, S2), and the sum of these (total of movement time) is then calculated (S3).

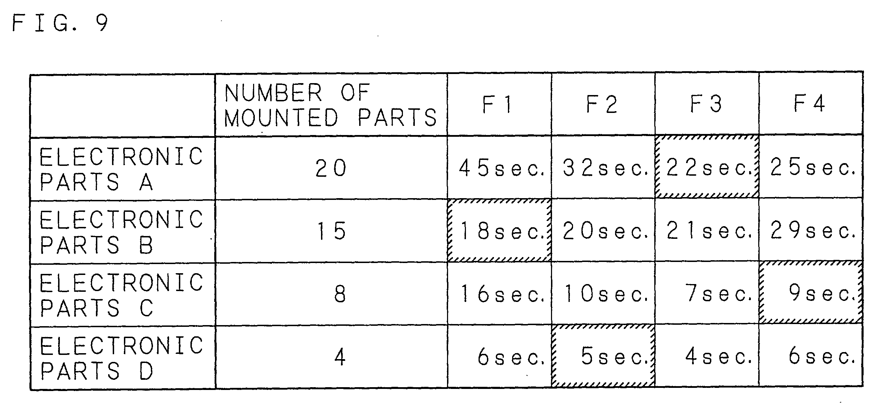

Since processing for all types of electronic parts is now complete (S4 : YES), based on the sum of the movement time distributions calculated for the respective electronic parts at S3 (total of the movement time), optimal feeders which are to store the electronic parts A, B, C and D are determined (S5). FIG. 9 shows, for each one of the feeders F1, F2, F3 and F4, one example of the total time of the movement time for the electronic parts A, B, C and D.

While a feeder associated with the shortest total time is basically determined in a similar manner to that of the first preferred embodiment, an optimal feeder is determined for electronic parts which are to be mounted in greater number with a higher priority. First, for the electronic parts A which are to be mounted in the largest number, the feeder F3 associated with the shortest total time (22 seconds) is set. As for the electronic parts B which are to be mounted in the second largest number, the feeder F1 associated with the shortest total time (18 seconds) is set. As for the electronic parts C which are to be mounted in the next largest number, although the feeder F3 associated with the shortest total time (7 seconds) is optimal, the feeder F4 associated with the next shortest total time (9 seconds) is set since the feeder F3 is already assigned for the electronic parts A. At last, for the electronic parts D which are to be mounted in the smallest number, although the feeder F3 associated with the shortest total time (4 seconds) is optimal, the feeder F2 associated with the next shortest total time (5 seconds) is set since the feeder F3 is already assigned for the electronic parts A. In the second preferred embodiment, since a priority is given to determination of a feeder which is for those electronic parts which are to be mounted in greater number and accordingly under a great influence by the movement time of the mounting head, the feeders are determined more efficiently.

The feeders may be determined such that the total sum of all movement time becomes the shortest as if to solve a minimization question using a combination optimizing scheme, at the stage of determining optimal feeders for a plurality of types of electronic parts.

Although the foregoing has described the examples in which a plurality of feeders are arranged only in one direction around the printed circuit board 1 in relation to the preferred embodiments above, the present invention is similarly applicable even to an example that the plurality of feeders are arranged in two or four directions around the printed circuit board 1.

As described above, the movement time required for the mounting head to move from the respective mounting points on the substrate to the respective storage units is calculated, the total movement time calculated for the plurality of mounting points is calculated for each storage unit, and a storage unit to store these parts is determined based on the calculated total time according to the present invention. Hence, since the storage units are set considering the movement time of the mounting head directly linked to the mounting time of the parts, it is possible to shorten the mounting time of the parts without fail.

Further, since a higher priority is given to determination of a storage unit which is to store parts which are to be mounted in a greater number than parts which are to be mounted in a smaller number at the stage of determining optimal storage units for a plurality of types of parts according to the present invention, it is possible to determine the storage units efficiently for the plurality of types of parts.

**Claims**

1. A parts arranging method for determining a storage unit (2) to store parts in a parts mounting apparatus in which a plurality of storage units (2) each storing one type of parts and a substrate (1) to which said parts are mounted at a plurality of mounting points (a1, a2, a3) are disposed at predetermined positions, and a mounting head (3) moves, accordingly transports a corresponding part from said storage units (2) and mounts the part to said substrate (1), said method being **characterized in that** movement time for said mounting head (3) to move from said respective mounting points (a1, a2, a3) on said substrate (1) to said respective storage units (2) is calculated, the total of a plurality of lengths of movement time calculated for said respective mounting points (a1, a2, a3) is calculated for each one of said storage units, and a storage unit (2) which is to store said parts is determined based on the calculated total time.

2. The parts arranging method according to Claim 1, wherein at the stage of determining said storage units (2) which are to store a plurality of types of parts, a storage unit (2) which is to store parts which are to be mounted in a great number is given priority.

3. A parts mounting apparatus which mounts parts to a substrate (1) at a plurality of mounting points (a1, a2, a3), **characterized in** comprising: a plurality of storage units (2) each storing one type of said parts; a mounting head (3) which transports a corresponding part from said storage units (2) and mounts the part to said substrate (1); a drive mechanism (4, 5) which drives said mounting head (3); and a determining unit which calculates movement time for said mounting head (3) to move from said respective mounting points (a1, a2, a3) on said substrate (1) to said respective storage units (2), calculates for each one of said storage units (2) the total of a plurality of lengths of movement time calculated for said respective mounting points (a1, a2, a3), and determines a storage unit (2) which is to store said parts based on the calculated total time.

4. The parts mounting apparatus according to Claim 3, wherein said drive mechanism (4, 5) drives said mounting head (3) in two-dimensional directions independently at the same time.

FIG. 1
PRIOR ART

2a  2b  2c  2d  2e  2f

A   B   C   D   E   F

3

1a        1a

•1a

1b•       •1c

Y       •1b

X

1

FIG. 2
 PRIOR ART

FIG. 3

FIG. 4

```
                          ┌─────────┐
                          │  START  │
                          └─────────┘
                               │
   ┌───────────────────────────┼───────────────────────────────┐
   │                                                    S1       │
   │         ┌─────────────────────────────────┐                │
   │         │ CALCULATE MOVEMENT              │                │
   │         │ TIME OF MOUNTING HEAD           │                │
   │         │ FROM MOUNTING POINT             │                │
   │         │ TO EACH FEEDER                  │                │
   │         └─────────────────────────────────┘                │
   │                          │                                 │
   │                                              S2            │
   │                    ╱────────────╲                         │
   │                 ╱   PROCESSING      ╲                      │
   │              ╱      FOR ALL MOUNTING   ╲         NO        │
   │              ╲      POINTS IS          ╱───────────────────┘
   │                 ╲   COMPLETE?       ╱
   │                    ╲────────────╱
   │                          │ YES
   │                                        S3
   │         ┌─────────────────────────────────┐
   │         │ CALCULATE TOTAL OF              │
   │         │ MOVEMENT TIME FOR               │
   │         │ EACH FEEDER                     │
   │         └─────────────────────────────────┘
   │                          │
   │                                              S4
   │                    ╱────────────╲
   │          NO     ╱   PROCESSING      ╲
   └─────────────────    FOR ALL TYPES OF  ╲
                   ╲     ELECTRONIC PARTS   ╱
                      ╲  IS COMPLETE?    ╱
                         ╲────────────╱
                               │ YES
                                          S5
              ┌─────────────────────────────────┐
              │ DETERMINE FEEDER TO             │
              │ STORE ELECTRONIC PARTS          │
              └─────────────────────────────────┘
                               │
                          ┌─────────┐
                          │   END   │
                          └─────────┘
```

FIG. 5

DISTRIBUTION FOR
MOUNTING POINT a1

MOVEMENT TIME

1.5
1.0
0.5

45°   45°
a1

PRINTED
CIRCUIT BOARD — 1

FIG. 6

DISTRIBUTION FOR
MOUNTING POINT a2

FIG. 7

EP 1 296 548 A2

FIG. 8

(UNIT:SECOND)

| | | | | | | | | | | | | | | | | | | |
|---|---|---|---|---|---|---|---|---|---|---|---|---|---|---|---|---|---|---|
| POINT a1 | 0.9 | 0.8 | 0.7 | 0.6 | 0.5 | 0.5 | 0.5 | 0.5 | 0.5 | 0.5 | 0.5 | 0.5 | 0.5 | 0.5 | 0.5 | 0.6 | 0.7 | 0.8 |
| POINT a2 | 0.6 | 0.6 | 0.6 | 0.6 | 0.6 | 0.6 | 0.6 | 0.6 | 0.6 | 0.8 | 0.9 | 1.0 | 1.1 | 1.2 | 1.3 | 1.4 | 1.5 | 1.6 |
| POINT a3 | 1.3 | 1.2 | 1.1 | 1.0 | 0.9 | 0.8 | 0.7 | 0.6 | 0.5 | 0.4 | 0.3 | 0.3 | 0.3 | 0.3 | 0.3 | 0.3 | 0.3 | 0.4 |
| TOTAL | 2.8 | 2.6 | 2.4 | 2.2 | 2.0 | 1.9 | 1.8 | 1.7 | 1.6 | 1.7 | 1.7 | 1.8 | 1.9 | 2.0 | 2.1 | 2.3 | 2.5 | 2.8 |

FIG. 9

| | NUMBER OF MOUNTED PARTS | F1 | F2 | F3 | F4 |
|---|---|---|---|---|---|
| ELECTRONIC PARTS A | 20 | 45sec. | 32sec. | 22sec. | 25sec. |
| ELECTRONIC PARTS B | 15 | 18sec. | 20sec. | 21sec. | 29sec. |
| ELECTRONIC PARTS C | 8 | 16sec. | 10sec. | 7sec. | 9sec. |
| ELECTRONIC PARTS D | 4 | 6sec. | 5sec. | 4sec. | 6sec. |

EP 1 296 548 A2